# EUROPÄISCHE PATENTSCHRIFT

(11) **EP 2 137 992 B1**
(45) Veröffentlichungstag und Bekanntmachung des Hinweises auf die Patenterteilung: **17.12.2014**
(21) Anmeldenummer: 08707603.0
(22) Anmeldetag: 07.02.2008
(51) Int. Cl.: H04W 24/00, G01R 31/319

(54) **MESSGERÄT MIT SERIELLER DIGITALER SCHNITTSTELLE**
MEASURING DEVICE HAVING SERIAL DIGITAL INTERFACE
APPAREIL DE MESURE COMPRENANT UNE INTERFACE NUMÉRIQUE SÉRIE

(30) Priorität: 25.04.2007 DE 102007019543
(43) Veröffentlichungstag der Anmeldung: 30.12.2009
(73) Patentinhaber: Rohde & Schwarz GmbH & Co. KG, 81671 München (DE)
(72) Erfinder: HOLZMANN, Gottfried, 85604 Zorneding (DE); MITTERMAIER, Werner, 85435 Erding (DE)
(74) Vertreter: Beder, Jens
(86) Internationale Anmeldenummer: PCT/EP2008/000954
(87) Internationale Veröffentlichungsnummer: WO 2008/131814

(56) Entgegenhaltungen:
- EP-A- 1 489 866
- EP-A- 1 564 918
- WO-A-2004/003583
- WO-A-2006/026799
- US-B1- 6 587 671

## Beschreibung

Die Erfindung betrifft ein Messgerät mit zumindest einer Hochfrequenzbaugruppe und zumindest einer Basisbandbaugruppe, wobei die Hochfrequenzbaugruppe und die Basisbandbaugruppe jeweils zumindest eine Zwischenfrequenzschnittstelle oder komplexe Basisbandschnittstelle aufweisen.

Aus der DE 103 37 913 A1 ist ein Messgerät bekannt, welches zumindest zwei Basisbandbaugruppen und zumindest zwei Hochfrequenzbaugruppen aufweist. Die Baugruppen sind über Schalteinrichtungen miteinander verbindbar, so dass eine änderbare Zuordnung zwischen unterschiedlichen Basisbandbaugruppen und Hochfrequenzbaugruppen möglich ist. Ferner ist es aus der DE 103 37 913 A1 bekannt, in einem Spektrumanalysator ein digitales Zwischenfrequenzsignal zu verwenden.

Die US Patentschrift 6,587,671 B1 zeigt eine Hochfrequenz-(HF-) Testvorrichtung. Die HF-Testvorrichtung ist dazu geeignet ein Funkkommunikationsgerät, beispielsweise ein Mobilfunkgerät in einer Mehrzahl von HF-Tests zu unterziehen. Eine HF-Quelle und ein HF-Empfänger werden dazu genutzt, mit dem Mobilfunkgerät zu kommunizieren und das Mobilfunkgerät zu steuern, während Parametermessungen entsprechend den HF-Tests ausgeführt werden. Gleichzeitige Messungen erlauben Durchführung gleichzeitiger Messprozesse und Kommunikationsprozesse innerhalb des RF-Testvorrichtung, um den Zeitaufwand des einzelnen HF-Tests zu verringern und den Messdurchsatz der HF-Testvorrichtung zu erhöhen.

Die internationale Offenlegungsschrift WO 2004/003583 A1 offenbart ein automatisiertes Messystem. Das automatisierte Messystem überträgt Messdaten von einem oder mehreren Testinstrumenten zu einem Prozessor und verarbeitet die Messdaten.

Die europäische Patentanmeldung EP 1 489 866 A1 zeigt eine Testvorrichtung, die innerhalb eines Gehäuses eine Verbindungseinheit, einen gemeinsamen Bus, Anschlusssteuervoreinheiten, Messeinheiten und eine Gesamtsteuereinheit anordnet. Die Verbindungseinheit ist geeignet, zumindest zwei Anschlüsse identischer oder unterschiedlicher Kommunikationssysteme zu verbinden.

Die europäische Patentanmeldung EP 1 564 918 A1 zeigt einen Kanalsimulator zur Simulation einer Funkverbindung zum Testen eines Funkgeräts. Es sind ein Daten-Generator zum Übermitteln von Daten an ein Sendesystem, ein Kanalsimulator, der als Eingangssignale Signale des Sendesystems erhält und eine Analysevorrichtung analysiert, welche Daten eines Empfangssystems zeigt, das Ausgangssignale des Kanalsimulators empfängt.

Die internationale Offenlegungsschrift WO 2006/026799 A2 zeigt eine Kanalsimulations- und Entwicklungsplattform, mit Eingangsmitteln zum Empfangen von Sendesignale repräsentierenden Eingangssignalen, Konvertierungsmittel zum Konvertieren der Eingangssignale aus dem Audio-/Video-Bereich in den analogen bzw. digitalen Basisband-Bereich. In umgekehrter Richtung dienen Steuerungsmittel zur Bereitstellung zumindest eines Kanalmodells, der durch sich im Verlauf der Simulationsrechnung ändernden Kanalparameter definiert ist, Signalverarbeitungsmittel zur Erzeugung zumindest eines Ausgangssignals durch Formen des Eingangssignals gemäß den Signalformungseigenschaften des Kanalmodells.

Bei höheren Dynamikanforderungen, die beispielsweise mehr als 12 Bit parallel betragen können, ist eine solche flexible Verbindung zwischen den Basisbandbaugruppen und den Hochfrequenzbaugruppen mit einem erheblichen Leitungs- und damit auch Schaltungsaufwand verbunden. Dies begrenzt die mögliche Anzahl von miteinander zu verschaltenden Komponenten.

Es ist daher die Aufgabe der Erfindung, ein Messgerät mit einer flexiblen Zuordnung verschiedener Baugruppen zu ermöglichen, bei dem der Leitungs- und Schalteraufwand gering ist.

Die Aufgabe wird durch das erfindungsgemäße Messgerät mit den Merkmalen des Anspruchs 1 gelöst.

Das erfindungsgemäße Messgerät umfasst zumindest eine erste Baugruppe und eine zweite Baugruppe. Die erste Baugruppe und die zweite Baugruppe weisen jeweils zumindest eine Zwischenfrequenzschnittstelle oder eine komplexe Basisbandschnittstelle auf. Erfindungsgemäß ist die Zwischenfrequenzschnittstelle bzw. die komplexe Basisbandschnittstelle als serielle, digitale Schnittstelle ausgebildet. Das Ausbilden der Schnittstellen als serielle, digitale Schnittstellen hat den Vorteil, dass pro Schnittstelle lediglich eine Leitung zur Übertragung des Zwischenfrequenzsignals bzw. des komplexen Basisbandsignals notwendig ist. Damit sinkt der Schaltungsaufwand im Vergleich zu einer parallelen Signalübertragung erheblich. Dabei werden gleichzeitig durch die Verwendung einer digitalen Schnittstelle Pegelfehler, wie sie durch Anpassung bei einer analogen Schnittstelle sowie durch die Frequenzgänge auftreten, verhindert. Auch ein Übersprechen zwischen den einzelnen Übertragungswegen wird verhindert, so dass die hiermit verbundenen Pegelfehler ebenfalls nicht auftreten können. Die erste Baugruppe kann insbesondere eine Hochfrequenzbaugruppe und die zweite Baugruppe eine Basisbandbaugruppe sein.

Aufgrund des im Vergleich zur parallelen Übertragung des Zwischenfrequenzsignals bzw. des komplexen Basisbandsignals geringeren Leitungsaufwands der damit verbundenen einfacheren Verbindungsmöglichkeit zwischen z. B. den Basisbandbaugruppen und den Hochfrequenzbaugruppen bzw. weiteren Baugruppen lassen sich in dem erfindungsgemäßen Messgerät eine Mehrzahl von Basisbandbaugruppen und Hochfrequenzbaugruppen oder weiteren Baugruppen in flexibler Weise miteinander verbinden.

In den Unteransprüchen sind vorteilhafte Weiterbildungen des erfindungsgemäßen Messgeräts ausgeführt.

Gemäß einer bevorzugten Ausführungsform weist das Messgerät eine Verbindungseinrichtung auf. Diese Verbindungseinrichtung umfasst zumindest zwei Eingangsanschlüsse und zwei Ausgangsanschlüsse. Jeder der Eingangsanschlüsse ist mit einem oder mehreren auswählbarem Ausgangsanschlüssen verbindbar. Durch das Vorsehen einer solchen Verbindungseinrichtung wird durch eine einzige Verbindungseinrichtung in dem Messgerät die Verschaltung der einzelnen Baugruppen - sowohl der Basisbandbaugruppen als auch der Hochfrequenzbaugruppen oder weiterer Baugruppen - miteinander ermöglicht. Durch die Vereinheitlichung der Schnittstellen in dem Messgerät vorhandener und miteinander zu verschaltender Baugruppen als serielle, digitale Schnittstellen können damit auch unterschiedliche Baugruppen, die in Modulbauweise gefertigt werden, in dem Messgerät eingesetzt und mit bereits vorhandenen, anderen Baugruppen verbunden werden. Die Verbindungseinrichtung kann insbesondere je nach dem, welche Baugruppen in dem Messgerät vorhanden sind, komplexe Basisbandsignale und/oder Zwischenfrequenzsignale übertragen.

Dabei ist es insbesondere vorteilhaft, wenn die Verbindungseinrichtung ein Kreuzschienenverteiler ist. Ein solcher Kreuzschienenverteiler ermöglicht es in besonders einfacher Weise Eingangsanschlüsse und Ausgangsanschlüsse miteinander zu verbinden. So lassen sich beispielsweise neun Eingangsanschlüsse und neun Ausgangsanschlüsse in flexibler Weise miteinander verbinden. Dabei ist der Verschaltung der Eingangsanschlüsse und Ausgangsanschlüsse lediglich dadurch Grenzen gesetzt, dass zwar jeweils ein Eingangsanschluss mit mehreren Ausgangsanschlüssen verbunden werden darf, umgekehrt jedoch das Verbinden von zwei Eingangsanschlüssen mit einem Ausgangsanschluss nicht möglich ist.

Gemäß einer weiteren bevorzugten Ausführungsform weist die erste Baugruppe und/oder die zweite Baugruppe jeweils einen Parallel-Seriell-Wandler auf. Durch die Parallel-Seriell-Wandlung innerhalb der jeweiligen Hochfrequenz- bzw. Basisbandbaugruppe ist eine besonders einfache Verbindung der Hochfrequenzbaugruppe mit einer Basisbandbaugruppe gewährleistet. Es kommt somit an den beteiligten Baugruppen jeweils einheitlich ein digitales, serielles Signal an, unabhängig von der innerhalb der betreffenden Baugruppe verwendeten Bandbreite.

Vorzugsweise ist eine Baugruppe eine Basisbandbaugruppe, die zumindest eine Signalerzeugungseinheit und eine Analyseeinheit aufweist. Sowohl der Signalerzeugungseinheit als auch der Analyseeinheit ist dabei jeweils eine serielle, digitale Schnittstelle in der Basisbandbaugruppe zugeordnet. Die einzelnen Signalzweige innerhalb der Basisbandbaugruppe können somit mit jeweils einem Eingangsanschluss bzw. einem Ausgangsanschluss der Verbindungseinrichtung oder aber mit korrespondierenden digitalen, seriellen Schnittstellen einer anderen Baugruppe direkt verbunden werden.

Dementsprechend ist in dem Messgerät vorzugsweise eine Baugruppe als eine Hochfrequenzbaugruppe mit einem Sendezweig und einem Empfangszweig ausgebildet. Der Sendezweig verbindet einen Messanschluss des Messgeräts mit einem Ausgangsanschluss der Verbindungseinrichtung und der Empfangszweig verbindet den Messanschluss des Messgeräts mit einem Eingangsanschluss der Verbindungseinrichtung. Die Messanschlüsse sind in Form einer bidirektionalen Geräteschnittstelle des Messgeräts unmittelbar an der Hochfrequenzbaugruppe angeordnet. Damit kann durch Austausch einer Hochfrequenzbaugruppe das Messgerät an bestimmte Verwendungen und Einsatzbereiche angepasst werden.

Gemäß einer weiteren bevorzugten Ausführungsform weist das Messgerät zumindest eine Schnittstellenbaugruppe mit zumindest einer seriellen, digitalen Schnittstelle auf. Mit Hilfe einer solchen Schnittstellenbaugruppe können Bearbeitungen auf der Ebene der Zwischenfrequenz bzw. des komplexen Basisbandsignals durchgeführt werden. Dies kann sowohl ein Signal betreffen, welches von der Hochfrequenzseite des Messgeräts kommt als auch ein Signal, welches von der Basisbandseite des Messgeräts kommt. Ein Beispiel für eine Schnittstellenbaugruppe ist eine Messgerätschnittstelle, so dass über die entsprechende Schnittstellenbaugruppe ein Gerät auf der Basisbandebene mit dem Messgerät verbunden werden kann.

Insbesondere ist es bevorzugt, in der Basisbandbaugruppe ein Equalizer-Filter zur Kompensation von Verzerrungen der zumindest einen Hochfrequenzbaugruppe vorzusehen. Auf diese Weise können Fehler, die in der Hochfrequenzbaugruppe beispielsweise aufgrund von NichtLinearitäten entstehen, innerhalb der Basisbandbaugruppe korrigiert werden.

Ein bevorzugtes Ausführungsbeispiel ist in der Figur dargestellt und wird in der nachfolgenden Beschreibung näher erläutert. Es zeigt:

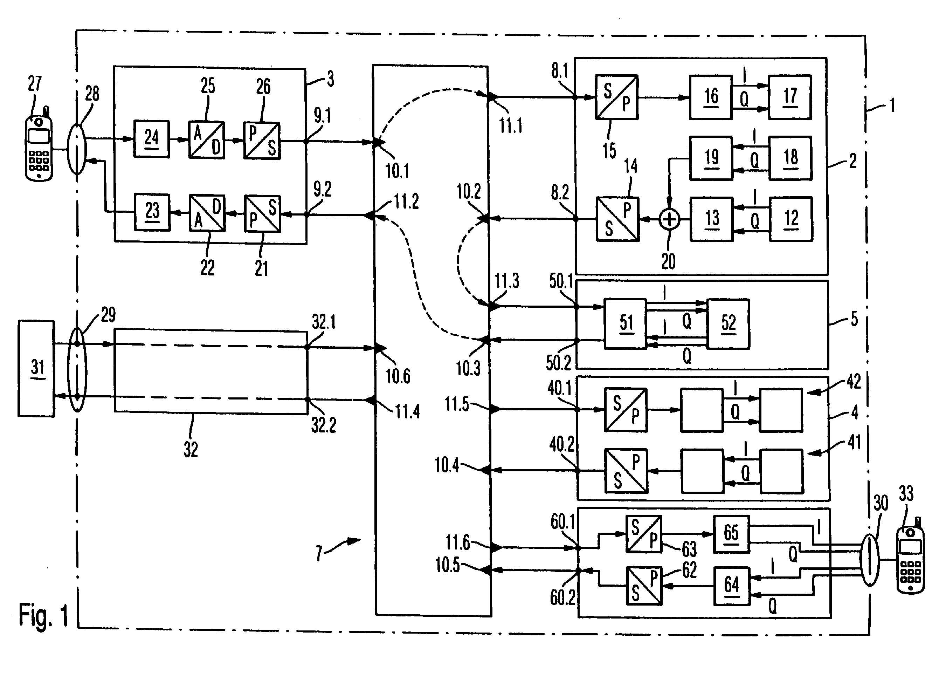

- Fig. 1: ein Blockschaltbild eines erfindungsgemäßen Messgeräts mit mehreren Basisband-, Hochfrequenz-, und Schnittstellenbaugruppen.

In der Fig. 1 ist ein Messgerät 1 dargestellt, wie es beispielsweise zum Testen von Mobilfunkgeräten verwendet wird. In dem erläuterten und dargestellten Ausführungsbeispiel wird von digitalen, seriellen Zwischenfrequenzschnittstellen als digitale, serielle Schnittstellen ausgegangen. Die Ausführungen treffen jedoch analog auch auf digitale, serielle Schnittstellen in Form von komplexen Basisbandschnittstellen zu.

Durch das Messgerät 1 wird einerseits ein Hochfrequenzsignal erzeugt, welches an das Mobilfunkgerät übermittelt wird, und andererseits wird das daraufhin von dem Mobilfunkgerät zurückgesendete Hochfrequenzsignal analysiert. Die Erzeugung einer Testsequenz, aus der nachfolgend ein Hochfrequenzsignal generiert wird, bzw. die Analyse des zurückgesendeten Signals erfolgt auf Basisbandebene. Dagegen erfolgt die Kommunikation, also das Übermitteln von Signalen an das zu testende Gerät und das Empfangen von von dem Gerät zurückgesendeten Signalen auf der Hochfrequenzebene. Hierzu ist in dem Messgerät 1 eine Basisbandbaugruppe 2 zum Erzeugen und Analysieren im Basisband und eine Hochfrequenzbaugruppe 3 zur Kommunikation mit dem zu testenden Gerät vorgesehen.

Die Basisbandbaugruppe und die Hochfrequenzbaugruppe sind über zumindest eine Zwischenfrequenzschnittstelle miteinander verbunden, wie dies nachfolgend noch ausführlich erläutert wird.

In dem Messgerät 1 des dargestellten Ausführungsbeispiels ist ferner eine zweite und eine dritte Basisbandbaugruppe 4 bzw. 5 und eine Zwischenfrequenzbaugruppe 6 als Schnittstellenbaugruppe vorgesehen. Zur Verbindung der einzelnen Baugruppen des Messgeräts 1 miteinander und insbesondere zur flexiblen Verschaltung der Baugruppen ist eine Verbindungseinrichtung 7 vorgesehen. Eine bevorzugte Ausführung des Messgeräts 1 sieht die Verbindungseinrichtung 7 als Kreuzschienenverteiler bzw. Multiplexer vor.

Um die erste Basisbandbaugruppe 2 mit der ersten Hochfrequenzbaugruppe 3 verbinden zu können, sind an der Basisbandbaugruppe 2 eine erste serielle, digitale Zwischenfrequenzschnittstelle 8.1 und eine zweite serielle, digitale Zwischenfrequenzschnittstelle 8.2 ausgebildet. In entsprechender Weise sind auch an der Hochfrequenzbaugruppe 3 zwei Zwischenfrequenzschnittstellen ausgebildet. Eine erste serielle, digitale Zwischenfrequenzschnittstelle 9.1 und eine zweite serielle, digitale Zwischenfrequenzschnittstelle 9.2 sind an der Hochfrequenzbaugruppe 3 vorgesehen, um eine Übertragung von Zwischenfrequenzsignalen von der Basisbandbaugruppe 2 zu der Hochfrequenzbaugruppe 3 bzw. in umgekehrter Richtung von der Hochfrequenzbaugruppe 3 zu der Basisbandbaugruppe 2 zu ermöglichen.

Die seriellen, digitalen Zwischenfrequenzschnittstellen 8.1, 8.2 sowie 9.1 und 9.2 werden über die Verbindungseinrichtung 7 miteinander verbunden. An der Verbindungseinrichtung 7 ist hierzu eine Mehrzahl von Eingangsanschlüssen 10.1 bis 10.6 ausgebildet. Ferner sind an der Verbindungseinrichtung 7 eine Mehrzahl von Ausgangsanschlüssen 11.1 bis 11.6 ausgebildet. In dem dargestellten Ausführungsbeispiel ist ein erster Ausgangsanschluss 11.1 der Verbindungseinrichtung 7 mit der ersten seriellen, digitalen Zwischenfrequenzschnittstelle 8.1 der Basisbandbaugruppe 2 verbunden. Ein erster Eingangsanschluss 10.1 ist mit dem ersten seriellen, digitalen Zwischenfrequenzanschluss 9.1 der Hochfrequenzbaugruppe 3 verbunden. Auf diese Weise kann bei entsprechender Ansteuerung der Verbindungseinrichtung 7 die erste serielle, digitale Zwischenfrequenzschnittstelle 9.1 der ersten Hochfrequenzbaugruppe 3 mit der ersten seriellen, digitalen Zwischenfrequenzschnittselle 8.1 der ersten Basisbandbaugruppe 2 verbunden werden.

Mit einem zweiten Eingangsanschluss 10.2 ist die zweite serielle, digitale Zwischenfrequenzschnittstelle 8.2 der ersten Basisbandbaugruppe 2 verbunden. Mit einem zweiten Ausgangsanschluss 11.2 ist die erste Hochfrequenzbaugruppe 3 an ihrer zweiten seriellen, digitalen Zwischenfrequenzschnittstelle 9.2 verbunden. Im einfachsten Fall kann somit ein durch die erste Basisbandbaugruppe 2 erzeugtes digitales Zwischenfrequenzsignal über die zweite serielle, digitale Zwischenfrequenzschnittstelle 8.2 der ersten Basisbandbaugruppe 2 und die zweite serielle, digitale Zwischenfrequenzschnittstelle 9.2 der ersten Hochfrequenzbaugruppe 3 an die erste Hochfrequenzbaugruppe 3 übermittelt werden. Innerhalb der Verbindungseinrichtung 7 werden hierzu der zweite Eingangsanschluss 10.2 und der zweite Ausgangsanschluss 11.2 miteinander verbunden. Werden zudem der erste Eingangsanschluss 10.1 und der zweite Ausgangsanschluss 11.1 miteinander verbunden, so kann in umgekehrter Richtung ein von der Hochfrequenzbaugruppe 3 empfangenes Signal an die Basisbandbaugruppe 2 übermittelt werden.

Während vorstehend ein einfaches Ausführungsbeispiel beschrieben wurde, bei dem unmittelbar die erste Basisbandbaugruppe 2 mit der ersten Hochfrequenzbaugruppe 3 verbunden ist, ist es in der Fig. 1 dargestellt, dass zusätzlich die dritte Basisbandbaugruppe 5 vorgesehen ist, um das von der ersten Basisbaugruppe 2 erzeugte Signal zu verändern. Die dritte Basisbandbaugruppe 5 kann beispielsweise ein Fading-Simulator sein. Die dritte Basisbandbaugruppe 5, die lediglich in stark vereinfachter Weise dargestellt ist, weist ebenfalls eine erste serielle, digitale Zwischenfrequenzschnittstelle 50.1 und eine zweite serielle, digitale Zwischenfrequenzschnittstelle 50.2 auf. Die erste digitale, serielle Zwischenfrequenzschnittstelle 50.1 ist mit einem dritten Ausgangsanschluss 11.3 der Verbindungseinrichtung 7 verbunden. In dem darstellten, bevorzugten Ausführungsbeispiel wird innerhalb der Verbindungseinrichtung 7 der zweite Eingangsanschluss 10.2 mit dem dritten Ausgangsanschluss 11.3 verbunden. Das von der ersten Basisbandbaugruppe 2 erzeugte und an die Verbindungseinrichtung 7 weitergeleitete digitale Zwischenfrequenzsignal wird damit der dritten Basisbandbaugruppe 5 zugeführt. Nach der Verarbeitung durch die dritte Basisbandbaugruppe 5 wird das Zwischenfrequenzsignal über die zweite serielle, digitale Zwischenfrequenzschnittstelle 50.2 der dritten Basisbandbaugruppe 5, die mit einem dritten Eingangsanschluss 10.3 der Verbindungseinrichtung 7 verbunden ist, über die Verbindungseinrichtung 7 an die erste Hochfrequenzbaugruppe 3 übermittelt. Hierzu ist innerhalb der Verbindungseinrichtung 7 eine Verbindung zwischen dem dritten Eingangsanschluss 10.3 und dem zweiten Ausgangsanschluss 11.2 hergestellt.

Die entsprechenden Verbindungen des beschriebenen Ausführungsbeispiels sind in der Figur 1 als gestrichelte Pfeile dargestellt.

Die erste Basisbandbaugruppe 2 weist eine Signalerzeugungseinheit 12 auf, mit der beispielsweise eine Testsequenz erzeugt wird. Die von der Signalerzeugungseinheit erzeugten I/Q-Signale werden an einen ersten Zwischenfrequenz-Sendeumsetzer 13 weitergeleitet. Durch den Zwischenfrequenz-Sendeumsetzer 13 werden parallele Signale (z. B. 12 Bit parallel) erzeugt. Diese parallelen Zwischenfrequenzsignale werden in serielle, digitale Zwischenfrequenzsignale umgewandelt. Hierzu ist der Zwischenfrequenz-Sendeumsetzer 13 mit einem Parallel-Seriell-Wandler 14 verbunden. Der Parallel-Seriell-Wandler 14 wandelt die ankommenden parallelen Zwischenfrequenzsignale in serielle, digitale Zwischenfrequenzsignale um. Dabei findet durch den Parallel-Seriell-Wandler 14 lediglich noch die Umwandlung der parallelen, digitalen Zwischenfrequenzsignale in serielle, digitale Zwischenfrequenzsignale statt. Der Parallel-Seriell-Wandler 14 ist mit der zweiten seriellen, digitalen Zwischenfrequenzschnittstelle 8.2 der ersten Basisbandbaugruppe 2 verbunden.

Das so der Verbindungseinrichtung 7 zugeführte Zwischenfrequenzsignal wird, wie dies vorher bereits erläutert wurde, in dem dargestellten Ausführungsbeispiel an die dritte Basisbandbaugruppe 5 weitergeleitet. Dort ist ein Sende-/Empfangsumsetzer 51 angeordnet, der ebenfalls einen Seriell-Parallel-Wandler aufweist und die so erzeugten I/Q-Signale an einen Fading-Abschnitt 52 weiterleitet. Mit Hilfe dieses Fading-Abschnitts 52 sind gezielt Fadingprofile einstellbar. Das entsprechend dem Profil bearbeitete Signal wird in umgekehrter Richtung wieder an den Sende-/Empfangs-Umsetzter 51 zurückgegeben, der nicht nur mit der ersten seriellen, digitalen Zwischenfrequenzschnittstelle 50.1 sondern auch mit der zweiten seriellen, digitalen Zwischenfrequenzschnittstelle 50.2 der dritten Basisbandbaugruppe 5 verbunden ist. Damit wird über die zweite serielle, digitale Zwischenfrequenzschnittstelle 50.2 der dritten Basisbandbaugruppe 5 ein weiterverarbeitetes Zwischenfrequenzsignal der Verbindungseinrichtung 7 zugeführt und durch diese an die erste Hochfrequenzbaugruppe 3 weitergeleitet.

Die erste Basisbandbaugruppe 2 umfasst weiterhin eine zweite Signalerzeugungseinheit 18, die mit einem zweiten Zwischenfrequenz-Umsetzer 19 verbunden ist. Das durch den ersten Zwischenfrequenz-Umsetzer 13 und den zweiten Zwischenfrequenz-Umsetzer 19 jeweils erzeugte Signal wird in einem Summierungspunkt 20 zusammengeführt und das zusammengeführte digitale Zwischenfrequenzsignal an den Parallel-Seriell-Wandler 14 weitergeleitet. Auf diese Weise ist es möglich, zunächst zwei unabhängige Signalsequenzen zu erzeugen und als Zwischenfrequenzsignale digital zusammenzuführen und so eine Signalüberlagerung zu realisieren.

Um eine Analyse von Signalen durchführen zu können, ist ferner in der ersten Basisbandbaugruppe 2 ein Seriell-Parallel-Wandler 15 vorgesehen. Der Seriell-Parallel-Wandler 15 ist mit der ersten seriellen, digitalen Zwischenfrequenzschnittstelle 8.1 einerseits und andererseits mit einem Zwischenfrequenz-Empfangsumsetzer 16 verbunden. Der Zwischenfrequenz-Empfangsumsetzer 16 erhält von dem Seriell-Parallel-Wandler 15 wieder parallelisierte Zwischenfrequenzsignale. Diese digitalen parallelen Zwischenfrequenzsignale werden von dem Zwischenfrequenz-Empfangsumsetzer 16 als I/Q-Signale ins Basisband umgesetzt und als analoge Basisbandsignale einer Auswerteeinheit 17 zugeführt.

In der ersten Hochfrequenzbaugruppe 3 ist ein Sendezweig und ein Empfangszweig ausgebildet. Der Sendezweig weist einen weiteren Seriell-Parallel-Wandler 21 auf, der mit einem Digital-Analog-Wandler 22 und nachfolgend einer Hochfrequenz-Sendeeinheit 23 verbunden ist.

Der Empfangszweig weist eine Hochfrequenz-Empfangseinheit 24 auf, die mit einem Analog-DigitalWandler 25 und nachfolgend einem Parallel-Seriell-Wandler 26 verbunden ist. Der Parallel-Seriell-Wandler 26 ist mit der ersten seriellen, digitalen Zwischenfrequenzschnittstelle 9.1 der ersten Hochfrequenzbaugruppe 3 verbunden. Innerhalb der ersten Basisbandbaugruppe 2 und der ersten Hochfrequenzbaugruppe 3 ist jeweils auf der Zwischenfrequenzebene eine Umwandlung der innerhalb der Baugruppen 2 bzw. 3 parallel geführten Signale in serielle, digitale Signale vorgesehen. Auf diese Weise muss über die Verbindungseinrichtung 7 lediglich ein serielles, digitales Zwischenfrequenzsignal übertragen werden. Im Vergleich zu einer Übertragung von parallelen Signalen sinkt damit der Leitungsaufwand- und auch insbesondere die Anzahl der Schalter beim Verbinden unterschiedlicher Baugruppen beträchtlich.

Um die erste Hochfrequenzbaugruppe 3 bzw. das Messgerät 1 mit einem Prüfling, beispielsweise einem Mobilfunkgerät 27 verbinden zu können, ist die erste Hochfrequenzbaugruppe 3 mit einem ersten Messanschluss 28 verbunden. Zur besseren Darstellung des systematischen Aufbaus ist in der Fig. 1 der erste Messanschluss 28 nicht innerhalb der ersten Hochfrequenzbaugruppe 3 ausgebildet. Es ist jedoch bevorzugt, das Messgerät 1 in Modulbauweise zu erstellen. Dann ist an der ersten Hochfrequenzbaugruppe 3 vorzugsweise der erste Messanschluss 28 unmittelbar ausgebildet.

Die zweite in dem Messgerät 1 dargestellte Basisbandbaugruppe 4 weist einen weiteren Signalerzeugungszweig 41 sowie einen weiteren Analysezweig 42 auf. Der Signalerzeugungszweig 41 und der zweite Auswertezweig 42 entsprechen in ihrem Aufbau grundsätzlich dem der ersten Basisbandbaugruppe 2. Auf eine erneute Ausführung hierzu wird daher verzichtet.

In der Fig. 1 ist in dem Messgerät 1 weiterhin eine als Schnittstellenbaugruppe 6 ausgeführte Zwischenfrequenzbaugruppe dargestellt. Die Schnittstellenbaugruppe 6 dient dazu, ein Zwischenfrequenzsignal aus dem Messgerät 1 herausführen zu können, um beispielsweise während der Entwicklung eines Mobilfunkgeräts auf der Zwischenfrequenzebene einen Test eines teilweise fertig gestellten Mobilfunkgeräts zu ermöglichen.

Die Schnittstellenbaugruppe 6 weist hierzu ebenfalls eine erste serielle, digitale Zwischenfrequenzschnittstelle 60.1 und eine zweite serielle, digitale Zwischenfrequenzschnittstelle 60.2 auf. Die erste serielle, digitale Zwischenfrequenzschnittstelle 60.1 der Schnittstellenbaugruppe 6 ist mit einem sechsten Ausgangsanschluss 11.6 der Verbindungseinrichtung 7 verbunden. Entsprechend ist ein fünfter Eingangsanschluss 10.5 der Verbindungseinrichtung 7 mit der zweiten seriellen, digitalen Zwischenfrequenzschnittstelle 60.2 verbunden. Die Schnittstellenbaugruppe 6 verbindet die Verbindungseinrichtung 7 mit einem zweiten Messanschluss 30 des Messgeräts 1. In der Schnittstellenbaugruppe 6 ist ein weiterer Parallel-Seriell-Wandler 62 sowie ein weiterer Seriell-Parallel-Wandler 63 angeordnet. Der weitere Parallel-Seriell-Wandler 62 ist über einen weiteren Zwischenfrequenz-Sendeumsetzer 64 mit dem zweiten Messanschluss 30 verbunden. Der weitere Seriell-Parallel-Wandler 63 ist dagegen über einen weiteren Zwischenfrequenz-Empfangsumsetzer 65 mit dem zweiten Messanschluss 30 verbunden. Über den zweiten Messanschluss werden somit insgesamt vier Signale (I/Q in, I/Q out) übertragen. Mit dem zweiten Messanschluss 30 ist z. B. ein lediglich teilweise funktionsfähiges weiteres Mobilfunkgerät 33 verbindbar, bei dem die Hochfrequenzkomponenten noch nicht funktionsfähig sind. Damit können Messungen an dem Mobilfunkgerät 33 an der Basisbandschnittstelle durchgeführt werden. So kann in nicht dargestellter Weise in der Verbindungseinrichtung 7 eine Verbindung z. B. zwischen dem zweiten Eingangsanschluss 10.2 und dem sechsten Ausgangsanschluss 11.6 eine Verbindung von der Basisbandbaugruppe 2 zu dem weiteren Mobilfunkgerät 33 erzeugt werden. Umgekehrt kann das digitale Zwischenfrequenzsignal, welches von dem weiteren Mobilfunkgerät 33 an das Messgerät 1 übermittelt wird, über die Verbindungseinrichtung 7 durch Verbinden des fünften Eingangsanschlusses 10.5 mit dem ersten Ausgangsanschluss 11.1 der Verbindungseinrichtung 7 unmittelbar wieder zurück an die erste Basisbandbaugruppe 2 übermittelt werden.

Somit ist eine direkte Kommunikation zwischen der Basisbandbaugruppe 2 und dem weiteren Mobilfunkgerät 33 auf der Zwischenfrequenzebene möglich.

In dem dargestellten bevorzugten Ausführungsbeispiel ist die erste Basisbandbaugruppe 2 über die dritte Basisbandbaugruppe 5, die einen Fading-Simulator 52 enthält, mit der ersten Hochfrequenzbaugruppe 32 verbunden. Gemäß einer alternativen Ausführungsform kann auch eine zweite Hochfrequenzbaugruppe 32 vorgesehen sein. Die zweite Hochfrequenzbaugruppe 32 verfügt ebenfalls über eine erste serielle, digitale Zwischenfrequenzschnittstelle 32.1 und eine zweite serielle, digitale Zwischenfrequenzschnittstelle 32.2. Die zweite Hochfrequenzbaugruppe 32 ist über ihre erste serielle, digitale Zwischenfrequenzschnittstelle 32.1 mit dem sechsten Eingangsanschluss 10.6 und über ihre zweite serielle, digitale Zwischenfrequenzschnittstelle 32.2 mit einem vierten Ausgangsanschluss 11.4 der Verbindungseinrichtung 7 verbunden. Durch die zweite Hochfrequenzbaugruppe 32 wird ein über die zweite serielle, digitale Zwischenfrequenzschnittstelle 32.2 ankommendes digitales Zwischenfrequenzsignal in ein analoges Hochfrequenzsignal umgewandelt und über einen dritten Messanschluss 29 ausgegeben. Mit dem dritten Messanschluss 29 ist beispielsweise ein externer Fading-Simulator 31 verbindbar. Das so gezielt einem Fadingprofil entsprechend bearbeitete Signal wird über den dritten Messanschluss 29 zurück an das Messgerät 1 übermittelt und dort der zweiten Hochfrequenzbaugruppe 32 zugeführt. Nach der Verarbeitung durch die zweite Hochfrequenzbaugruppe 32 wird das gedämpfte und nun wieder als digitales Zwischenfrequenzsignal vorliegende Signal über die Verbindungseinrichtung 7 z. B. dem Mobilfunkgerät 27 zugeführt. Hierzu wird in der Verbindungseinrichtung 7 der sechste Eingangsanschluss 10.6 mit dem zweiten Ausgangsanschluss 11.2 verbunden. Anstelle der zuvor durchgeführten Dämpfung durch die dritte Basisbandbaugruppe 5 erfolgt in dem letztgenannten Ausführungsbeispiel eine Ausgabe eines Hochfrequenzsignals durch die zweite Hochfrequenzbaugruppe 32 sowie eine externe Dämpfung über den externen Fading-Simulator 31. In dem dargestellten Ausführungsbeispiel der Figur 1 ist zur Entkopplung der dritte Messanschluss 29 als bidirektionale Schnittstelle ausgebildet, wobei für jede Übertragungsrichtung jeweils eine Buchse zur Verfügung steht. Als Messanschluss wird im Sinne der vorliegenden Erfindung jede äußere Schnittstelle des Messgeräts 1 bezeichnet, an die ein weiteres Gerät angeschlossen werden kann. Dieses weitere Gerät kann entweder ein zu prüfendes Gerät oder aber ein zur Bearbeitung des Signals eingesetztes Zusatzgerät wie beispielsweise der Fading-Simulator 31 sein.

Die zweite Hochfrequenzbaugruppe 32 ist im Wesentlichen identisch mit der ersten Hochfrequenzbaugruppe 3 aufgebaut, so dass auf eine erneute vollständige Beschreibung verzichtet wird.

Zur Festlegung der Verbindungen innerhalb der Verbindungseinrichtung 7 ist vorzugsweise das Messgerät 1 mit einem in der Fig. 1 nicht dargestellten Display ausgestattet. Dort sind die einzelnen Baugruppen, also die Hochfrequenzbaugruppen 3, 32, sowie die Basisbandbaugruppen 2, 4 und 5 und die Zwischenfrequenzbaugruppe 6 beispielsweise symbolisch dargestellt, so dass die Verschaltung der einzelnen Baugruppen dargestellt ist und für einen Benutzer erkennbar ist.

Die Erfindung ist nicht auf das dargestellte Ausführungsbeispiel beschränkt. Vielmehr sind auch Kombinationen einzelner Merkmale miteinander möglich.

## Patentansprüche

1. Messgerät zum Testen eines zumindest teilweise fertigen Mobilfunkgeräts mit zumindest einer Hochfrequenzbaugruppe (3) und einer Basisbandbaugruppe (2), wobei die Hochfrequenzbaugruppe (3) und die Basisbandbaugruppe (2) jeweils zumindest eine Zwischenfrequenzschnittstelle oder komplexe Basisbandschnittstelle aufweisen,
wobei die Zwischenfrequenzschnittstellen bzw. die komplexen Basisbandschnittstellen als serielle, digitale Schnittstellen (8.1, 8.2, 9.1, 9.2, 40.1, 40.2, 50.1, 50.2) ausgebildet sind,
**dadurch gekennzeichnet, dass**
- die Hochfrequenzbaugruppe (3) zum Übermitteln von Signalen an das zu testende, zumindest teilweise fertige Mobilfunkgerät (27) und zum Empfangen von dem zu testenden, zumindest teilweise fertigen Mobilfunkgerät (27) zurückgesendeten Signalen ausgebildet ist und
zumindest zwei Zwischenfrequenzschnittstellen oder zwei komplexe Basisbandschnittstellen (9.1, 9.2) aufweist,
- die Basisbandbaugruppe (2) zur Erzeugung einer Testsequenz und zur Analyse des zurückgesendeten Signals ausgebildet ist und zumindest zwei Zwischenfrequenzschnittstellen oder zwei komplexe Basisbandschnittstellen (8.1, 8.2) aufweist, und
- die Hochfrequenzbaugruppe (3) und die Basisbandbaugruppe (2)
- mittels der Zwischenfrequenzschnittstellen bzw. der komplexen Basisbandschnittstellen (8.1, 8.2, 9.1, 9.2) und
- über eine Verbindungseinrichtung (7), welche zumindest zwei Eingangsanschlüsse (10.1,...10.6) und zumindest zwei Ausgangsanschlüsse (11.1,...11.6) aufweist, wobei jeder Eingangsanschluss (10.1,...10.6) mit einem oder mehreren auswählbaren Ausgangsanschlüssen (11.1,...11.6) verbindbar ist,
- miteinander und
- mit einer weiteren Baugruppe (5) mit zumindest zwei Zwischenfrequenzschnittstellen oder komplexen Basisbandschnittstellen (50.1, 50.2) zur Veränderung eines von der Basisbandbaugruppe (2) erzeugten Signals verbindbar sind.

2. Messgerät nach Anspruch 1,
**dadurch gekennzeichnet,**
**dass** die Verbindungseinrichtung (7) ein Kreuzschienenverteiler ist.

3. Messgerät nach einem der Ansprüche 1 bis 2,
**dadurch gekennzeichnet,**
**dass** die Hochfrequenzbaugruppe (3) und/oder die Basisbandbaugruppe (2) jeweils einen Parallel-Seriell-Wandler (14, 15, 21, 26) aufweisen.

4. Messgerät nach einem der Ansprüche 1 bis 3,
**dadurch gekennzeichnet,**
**dass** dieBasisbandbaugruppe (2) zumindest eine Signalerzeugungseinheit (12, 18) und eine Analyseeinheit (17) umfasst und dass die Signalerzeugungseinheit (12, 18) und die Analyseeinheit (17) mit jeweils einer seriellen, digitalen Schnittstelle (8.2; 8.1) verbunden sind.

5. Messgerät nach einem der Ansprüche 1 bis 4,
**dadurch gekennzeichnet,**
**dass** die Hochfrequenzbaugruppe (3) e einen Sendezweig und einen Empfangszweig aufweist, wobei der Sendezweig einen Messanschluss (28) des Messgeräts mit einem Ausgangsanschluss (11.2) einer Verbindungseinrichtung (7) verbindet und der Empfangszweig den Messanschluss (28) des Messgeräts (1) mit einem Eingangsanschluss (10.1) der Verbindungseinrichtung (7) verbindet.

6. Messgerät nach einem der Ansprüche 1 bis 4,
**dadurch gekennzeichnet,**
**dass** das Messgerät (1) zumindest eine Schnittstellenbaugruppe (6) mit einer seriellen, digitalen Schnittstelle (60.1, 60.2) aufweist.

7. Messgerät nach einem der Ansprüche 1 bis 6,
**dadurch gekennzeichnet,**
**dass** die Basisbandbaugruppe (2) ein Equalizer-Filter zur Kompensation von Verzerrungen der zumindest einen Hochfrequenzbaugruppe (3) aufweist.

## Claims

1. Measuring device for testing an at least partially complete mobile radio device having at least one radio-frequency assembly (3) and one baseband assembly (2), the radio-frequency assembly (3) and the baseband assembly (2) in each case having at least one intermediate-frequency interface or complex baseband interface,
wherein the intermediate-frequency interfaces or the complex baseband interfaces, respectively, are configured as serial digital interfaces (8.1, 8.2, 9.1, 9.2, 40.1, 40.2, 50.1, 50.2),
**characterized in that**
- the radio-frequency assembly (3) is configured for conveying signals to the at least partially complete mobile radio device (27) to be tested and for receiving signals from the at least partially complete mobile radio device (27) to be tested, and
has at least two intermediate-frequency interfaces or two complex baseband interfaces (9.1, 9.2),
- the baseband assembly (2) is configured for generating a test sequence and for analysing the signal sent back and has at least two intermediate-frequency interfaces or two complex baseband interfaces (8.1, 8.2) and
- can be connected by means of the intermediate-frequency interfaces or the complex baseband interfaces, respectively (8.1, 8.2, 9.1, 9.2) and
- via a connecting device (7) which has at least two input connections (10.1, ... 10.6) and at least two output connections (11.1, ... 11.6), wherein each input connection (10.1, ... 10.6) can be connected to one or more selectable output connections (11.1, ...11.6),
- to one another and
- to a further assembly (5) having at least two intermediate-frequency interfaces or complex baseband interfaces (50.1, 50.2) for changing a signal generated by the baseband assembly (2).

2. Measuring device according to Claim 1,
**characterized in that**
the connecting device (7) is a crossbar distributor.

3. Measuring device according to one of Claims 1 to 2,
**characterized in that**
the radio-frequency assembly (3) and/or the baseband assembly (2) have in each case a parallel/serial converter (14, 15, 21, 26).

4. Measuring device according to one of Claims 1 to 3,
**characterized in that**
the baseband assembly (2) comprises at least one signal generating unit (12, 18) and one analysing unit (17) and **in that** the signal generating unit (12, 18) and the analysing unit (17) are connected to in each case one serial digital interface (8.2; 8.1).

5. Measuring device according to one of Claims 1 to 4,
**characterized in that**
the radio-frequency assembly (3) has a transmit branch and a receive branch, the transmit branch connecting a test connection (28) of the measuring device to an output connection (11.2) of a connecting device (7) and the receive branch connecting the test connection (28) of the measuring device (1) to an input connection (10.1) of the connecting device (7).

6. Measuring device according to one of Claims 1 to 4,
**characterized in that**
the measuring device (1) has at least one interface assembly (6) having a serial digital interface (60.1, 60.2).

7. Measuring device according to one of Claims 1 to 6,
**characterized in that**
the baseband assembly (2) has an equalizer filter for compensating for distortions of the at least one radio-frequency assembly (3).

## Revendications

1. Appareil de mesure pour tester un téléphone mobile au moins partiellement prêt comportant au moins un module haute fréquence (3) et un module de bande de base (2), dans lequel le module haute fréquence (3) et le module de bande de base (2) présentent respectivement au moins une interface à fréquence intermédiaire ou une interface de bande de base complexe,
dans lequel les interfaces à fréquence intermédiaire ou les interfaces de bande de base complexes sont réalisées sous la forme d'interfaces numériques séries (8.1, 8.2, 9.1, 9.2, 40.1, 40.2, 50.1, 50.2),
**caractérisé en ce que**
- le module haute fréquence (3) est réalisé en vue de transmettre des signaux au téléphone mobile au moins partiellement prêt (27) à tester et en vue de recevoir des signaux renvoyés par le téléphone mobile au moins partiellement prêt (27) à tester et
présente au moins deux interfaces à fréquence intermédiaire ou deux interfaces de bande de base complexes (9.1, 9.2),
- le module de bande de base (2) est réalisé en vue de générer une séquence test et en vue de l'analyse du signal renvoyé et présente au moins deux interfaces à fréquence intermédiaire ou deux interfaces de bande de base complexes (8.1, 8.2),
et
- le module haute fréquence (3) et le module de bande de base (2) peuvent être reliés
- au moyen des interfaces à fréquence intermédiaire ou des interfaces de bande de base complexes (8.1, 8.2, 9.1, 9.2) et
- par l'intermédiaire d'un dispositif de liaison (7), qui présente au moins deux connexions d'entrée (10.1,... 10.6) et au moins deux connexions de sortie (11.1, ... 11.6), dans laquelle chaque connexion d'entrée (10.1, ... 10.6) peut être reliée à une ou plusieurs connexions de sortie sélectionnées (11.1, ... 11.6),
- l'un avec l'autre et
- avec un autre module (5) comportant au moins deux interfaces à fréquence intermédiaire ou interfaces de bande de base complexes (50.1, 50.2) en vue de la transformation d'un signal généré par le module de bande de base (2).

2. Appareil de mesure selon la revendication 1, **caractérisé en ce que**
le dispositif de liaison (7) est un commutateur à barres croisées.

3. Appareil de mesure selon l'une des revendications 1 à 2, **caractérisé en ce que**
le module haute fréquence (3) et/ou le module de bande de base (2) présentent respectivement un transducteur parallèle-série (14, 15, 21, 26).

4. Appareil de mesure selon l'une des revendications 1 à 3, **caractérisé en ce que**
le module de bande de base (2) comporte au moins une unité de génération de signaux (12, 18) et une unité d'analyse (17) et **en ce que** l'unité de génération de signaux (12, 18) et l'unité d'analyse (17) sont reliées à une interface numérique série respective (8.2; 8.1).

5. Appareil de mesure selon l'une des revendications 1 à 4, **caractérisé en ce que**
le module haute fréquence (3) présente une branche d'envoi et une branche de réception, dans lequel la branche d'envoi relie un raccord de mesure (28) de l'appareil de mesure à une connexion de sortie (11.2) d'un dispositif de liaison (7) et la branche de réception relie le raccord de mesure (28) de l'appareil de mesure (1) à une connexion d'entrée (10.1) du dispositif de liaison (7).

6. Appareil de mesure selon l'une des revendications 1 à 4, **caractérisé en ce que**
l'appareil de mesure (1) présente au moins un module d'interface (6) comportant une interface numérique série (60.1, 60.2).

7. Appareil de mesure selon l'une des revendications 1 à 6, **caractérisé en ce que**
le module de bande de base (2) présente un filtre égaliseur en vue de la compensation de distorsions du au moins un module haute fréquence (3).
